# EUROPEAN PATENT SPECIFICATION

(11) **EP 2 474 877 B1**
(45) Date of publication and mention of the grant of the patent: **19.11.2014**
(21) Application number: 11150161.5
(22) Date of filing: 05.01.2011
(51) Int. Cl.: G06F 1/16, G01R 33/00, G01R 33/028, G06K 19/12, H04B 17/00, H04M 1/04, H04L 12/28, H04B 1/38

(54) **System & method for using magnetometer readings to control electronic devices**
System und Verfahren mit Magnetometer-Ablesungen zur Steuerung von elektronischen Vorrichtungen
Système et procédé d'utilisation de lecteurs de magnétomètre pour contrôler des dispositifs électroniques

(43) Date of publication of application: 11.07.2012
(73) Proprietor: BlackBerry Limited, Waterloo, ON N2K 0A7 (CA)
(72) Inventor: Parco, Adam Louis, Waterloo Ontario N2L 5R9 (CA); Almalki, Nazih, Waterloo Ontario N2L 3W8 (CA); Dods, Jeffrey Alton Hugh, Waterloo Ontario N2L 3W8 (CA)
(74) Representative: Moore, Barry

(56) References cited:
- EP-A1- 2 194 694
- EP-A2- 1 780 505
- US-A1- 2005 014 526
- US-A1- 2010 081 473

## Description

The following relates generally to systems and methods for using magnetometer readings to control electronic devices.

Mobile communication devices, such as cellular telephones, PDAs, smart phones, tablet computers, etc., can operate in many different locations and under various circumstances. Changes in the environment in which the device operates can affect usability of the device. For example, the device may be used in various fixtures. However, the device may be coupled to the fixture in various orientations, which can impede usage of some features.

U.S. Published Patent Application No. 2005/0014526 A1 discloses a portable communications device including a transceiver module and a cover detachably installed on the transceiver module. The cover contains magnetic media disposed on the cover, the magnetic media emitting a magnetic flux for identifying the cover. The transceiver module includes a magnetic sensor for measuring the magnetic flux emitted by the magnetic media and generating a corresponding output signal and a control circuit for receiving the output signal from the magnetic sensor and determining an identification of the cover based on the received output signal.

U.S. Published Patent Application No. 2010/0081473 A1 discloses a mobile computing device ('MCD') and docking station ('dock') individually equipped with features and components that enable charging/power signals to be communicated from the dock to the MCD without use of connectors. Other embodiments provide for the MCD or the dock to identify an orientation of the MCD as retained on the docking station. As an addition or alternative, magnetic coupling may be used to maintain and/or orient the two devices in a mated position.

European Published Patent Application No. 1 780 505 A2 discloses that a magnetic field sensing device can be realized by using a magnetic sensor in electronic compassing as well as switching. A magnet can be brought in close proximity to the magnetic sensor within an electronic compass to generate a signal that a portable information device has been closed. This signal can be input to a processor or other circuitry to initiate a response to the portable information device being closed. When the magnet is moved out of close proximity to the magnetic sensor, the magnetic sensor can be used in the electronic compass. Thus, a magnetic sensor can serve two functions, namely compassing and switching, reducing the need for separate sensors to perform both functions.

EP 2 194694 relates to a mobile device and holster system which includes a mobile device that has a front face and a back face opposite the front face, the back face including an elastomeric layer. A pair of longitudinal sides are coupled to the front face and back face, and a pair of latitudinal sides are also coupled to the front face and back face. The back face or the longitudinal sides define a recessed slot extending along a longitudinal length of the back face or longitudinal sides, respectively. The recessed slot defines an open end at at least one of the latitudinal sides and the recessed slot has a recessed slot surface that comprises a low-friction material. The holster comprises a pocket defining an open top end configured to receive the mobile device. A rail extends longitudinally along an interior side of the pocket, and the rail is configured to correspond with and slidably engage the slot on the mobile device. The holster includes a magnet for magnetically interacting with the mobile device.

### GENERAL

The present invention provides a method of controlling an electronic device according to claim 1.

There is also provided an electronic device comprising a processor, memory, and a magnetometer according to claim 10.

There is also provided a computer readable storage medium according to claim 11.

### BRIEF DESCRIPTION OF THE DRAWINGS

Embodiments will now be described by way of example only with reference to the appended drawings wherein:
FIG. 1 is a perspective view of an example mobile device displaying an electronic compass.
FIG. 2 is a perspective view of an example mobile device connected to a cradle-type fixture.
FIG. 3 is a perspective view of an example mobile device while holstered in one orientation.
FIG. 4 is a perspective view of an example mobile device while holstered in another orientation.
FIG. 5 is a block diagram of an example configuration for a mobile device comprising a magnetometer.
FIG. 6 is a diagram illustrating a magnetic field vector in three dimensional (3D) space.
FIG. 7 is a perspective view of a holster having a series of magnets.
FIG. 8 is a diagram illustrating a magnetic influence of the series of magnets shown in FIG. 7 on a magnetometer placed within an area defined by the magnets.
FIG. 9 is a flow chart illustrating an example set of computer executable operations for determining one or more actions to be executed according to a detected magnetic signature.
FIG. 10 is a flow chart illustrating an example set of computer executable operations for comparing a magnetic field vector to predetermined magnetic signatures.
FIG. 11 is a flow chart illustrating an example set of computer executable operations for determining one or more actions based on a detected magnetic signature.
FIG. 12 is a flow chart illustrating an example set of computer executable operations for controlling an electronic device upon detecting it has been coupled to an in-vehicle cradle.
FIG. 13 is a flow chart comprising an example set of computer executable operations for controlling a notification profile according to a fixture type.
FIG. 14 is a block diagram of an example configuration for a mobile device.

### DETAILED DESCRIPTION

A magnetometer is an instrument used to measure the strength and/or direction of the magnetic field in the vicinity of the instrument. Many electronic devices exist that utilize a magnetometer for taking measurements for a particular application, e.g. metal detectors, geophysical instruments, aerospace equipment, and mobile communications devices such as cellular telephones, PDAs, smart phones, tablet computers, etc., to name a few.

It has been found that readings taken by a magnetometer in an electronic device can also be used to determine if one or more properties of particular readings match one of a set of predetermined magnetic signatures, wherein the magnetic signatures are indicative of an expected magnetic influence from another object (e.g. another device such as a holster, cradle, etc. or component thereof), which enables other objects or orientations with respect thereto to be distinguished from each other. By associating one or more actions with each magnetic signature, discovering a matched signature can be used to control the electronic device in a particular way. The actions can be used to adapt the electronic device to its current state or environment (e.g. when holstered, cradled, etc.) in order to pre-emptively perform operations and/or suppress operations accordingly. In this way, not only can data obtained from a magnetometer be intelligently harnessed to perform relevant actions, but power consumption and bandwidth conservation can be employed when the device's state is indicative of an appropriate environment in which to suppress features such as alerts and data communications.

Although the following examples are presented in the context of mobile communication devices, the principles may equally be applied to other devices such as applications running on personal computers, embedded computing devices, other electronic devices, and the like.

For clarity in the discussion below, mobile communication devices are commonly referred to as "mobile devices" for brevity. Examples of applicable mobile devices include without limitation, cellular phones, cellular smart-phones, wireless organizers, pagers, personal digital assistants, computers, laptops, handheld wireless communication devices, wirelessly enabled notebook computers, portable gaming devices, tablet computers, or any other portable electronic device with processing and communication capabilities.

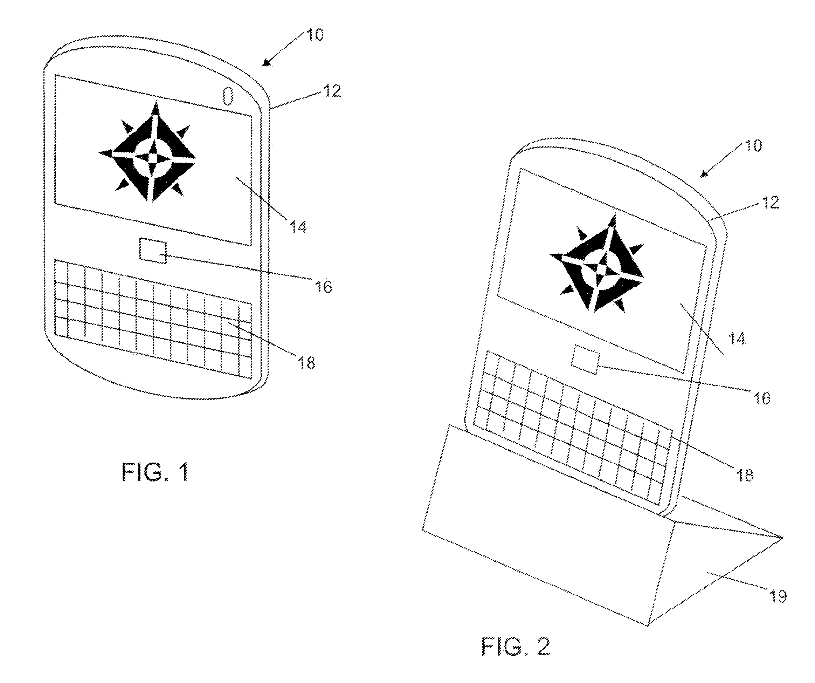

An exterior view of an example mobile device 10 is shown in FIG.1 The mobile device 10 in this example comprises a housing 12 which supports a display 14, a positioning device 16 (e.g. track pad, track wheel, etc.), and a keyboard 18. The keyboard 18 may comprise a full-Qwerty (as shown) set of keys but may also provide a reduced Qwerty set of keys (not shown) in other embodiments.

FIG. 2 illustrates a cradle-type fixture, hereinafter a "cradle 19" for brevity. The cradle 19 may be any suitable mounting device or fixture which enables the mobile device 10 to be coupled thereto and may provide data connectivity, power connectivity, or both. Example cradles 19 include, without limitation, an in-vehicle cradle 19, a desktop computer or other desk cradle 19, bedside/alarm clock cradle 19, etc. The cradle 19 may have one or more magnets, magnetized materials, magnetic coatings, may create a magnetic field due to operation of one or more of its components, or otherwise provide a magnetic influence on the mobile device 10 when the mobile device 10 is in its vicinity, connected thereto, or when they are otherwise coupled together. Such a magnetic influence is often unique to the particular cradle 19 or may be distinguishable from magnetic influences from other devices or accessories. As such, when the mobile device 10 can detect the magnetic influence of the cradle 19, it can determine a magnetic signature indicative of the magnetic influence and thus that a coupling likely exists between the mobile device 10 and the cradle 19. The cradle 19 or a component thereof may therefore comprise an object that provides such a magnetic influence.

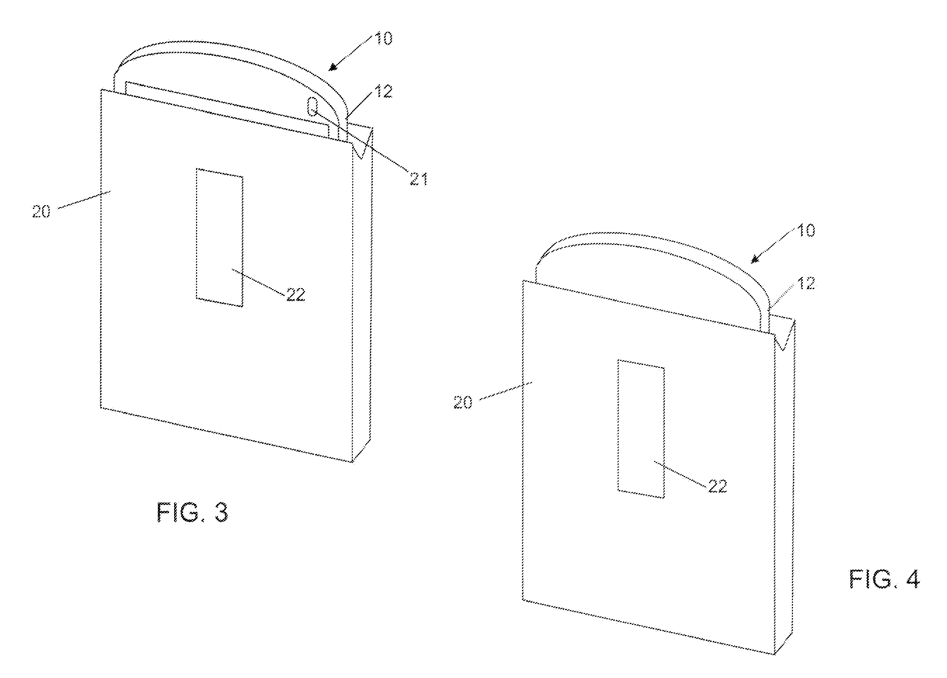

FIG. 3 illustrates a holster 20 for the mobile device 10. The holster 20 is typically used to stow and protect the outer surfaces of the housing 12, display 14, positioning device 16, keyboard 18, etc. and may be used to trigger other features such as a notification profile, backlight, phone, etc. In this example, the holster 20 comprises a clip 22 to facilitate supporting the holster 20 and thus the mobile device 10 on a belt or other object. It can be seen in FIG. 3 that the mobile device 10 can be inserted into the holster 20 in a particular orientation, which orientation in the example shown allows a notification light 21 to be visible. It can be appreciated that other types of holsters 20 may allow for different components of the mobile device 10 to be visible in particular orientations. For example, a holster 20 comprising a cut-out window (not shown) may permit the display 14 to be seen if the mobile device 10 is holstered such that the display 14 aligns with the cut-out. Conversely, as shown in FIG. 4, the mobile device 10 may be inserted in a way that obstructs the light 21, in this example. In such a scenario, the mobile device 10 may be considered "upside down" and thus the user would be unable to view the notification light 21 whilst in this orientation. When such holsters 20 provide a magnetic influence on a mobile device 10 that has been holstered, e.g. by having one or more magnets, magnetized materials, magnetic coatings, etc.; a coupling of the mobile device 10 and the holster 20 can be detected, similar to when the mobile device 10 is cradled. It has also been recognized that the magnetic influence provided by the holster 20 on the mobile device 10 may also vary depending on the orientation of the mobile device 10 relative to the holster 20. As such, the magnetic influence provided in the orientation shown in FIG. 3 may differ from that provided in the orientation shown in FIG. 4. Consequently, the mobile device 10 can detect its orientation with respect to a fixture or accessory such as holster from a magnetic reading, e.g. using a magnetometer. The holster 20 or a component thereof may therefore comprise an object that provides such a magnetic influence.

Accordingly, it can be appreciated that a magnetic reading obtained by the mobile device 10 can be used to not only detect the presence of or coupling to a particular other object (e.g. cradle 19, holster 20, or other device or accessory), but also to determine the mobile device's orientation with respect to that other object. In either case, the magnetic influence of the other object, when distinguishable from other objects or orientations, provides a unique magnetic signature that enables the mobile device 10 to determine its current state with respect to such other objects or orientations relative thereto, and to enable one or more actions to be executed according to the current state. For example, as will be explained in greater detail below, alerts, notifications, power consumption, and the use of various applications can be controlled based on the presence of a particular other device and/or the orientation of the mobile device 10 relative to that other object.

It can also be appreciated that the mobile device 10 shown in FIGS. 1 to 4 is provided as an example for illustrative purposes only. For example, other mobile devices 10, may comprise a touchscreen display and a "slide-out" keyboard 18. In operation, such a touchscreen display can be used to interact with applications on the mobile device 10 and the keyboard 18 may be slid out from behind the touchscreen display, when desired, e.g. for typing or composing an email, editing a document, etc. In other embodiments, the mobile device housing 12 may provide a foldable or flippable, clamshell type mechanism to fold the display 14 towards the keyboard 18 to effectively transition the mobile device 10 between an operable or open state and a standby or closed state. Mobile devices 10 that comprise such different states themselves may also produce magnetic signatures indicative of the state of the mobile device 10 due to the influence of magnets or magentized/magnetic material or an influence on the Earth's magnetic field in the vicinity of the mobile device 10. As such, the magnetic signatures discussed below can also apply to the mobile device 10 being controlled and thus the mobile device 10 may itself comprise an object that provides a particular magnetic signature according to the principles discussed herein. For example, for a clam-shell type housing, when unfolded, the display 14 would be visible whereas it typically is not when folded. If distinguishable magnetic influences in these different states are predetermined, the mobile device 10 can be controlled according to in which state it is currently.

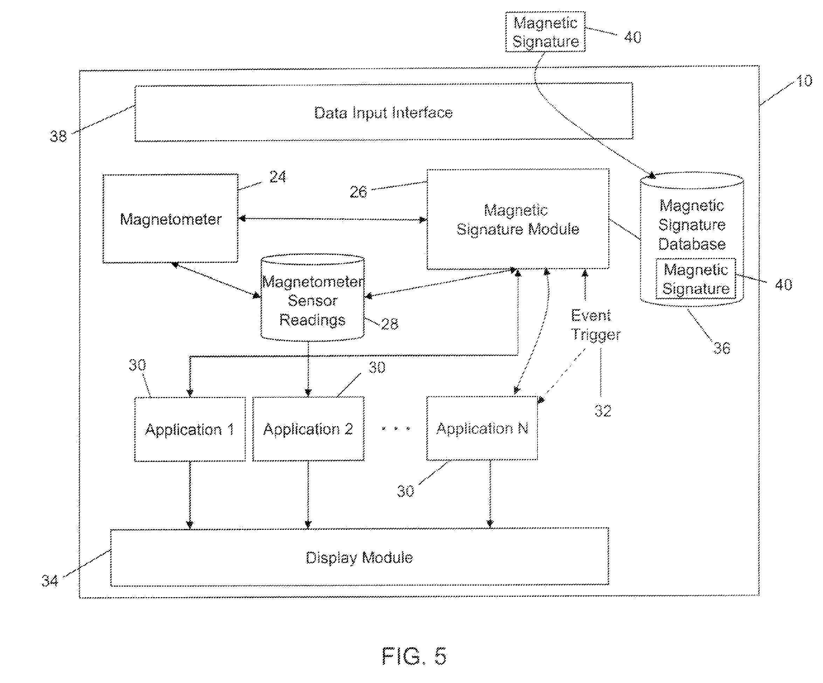

An example configuration for a mobile device 10 comprising a magnetometer 24 is shown in FIG. 5. It can be appreciated that the magnetometer 24 is, in an example embodiment, a vector type, three-axis magnetometer 24 that is operable to obtain readings along each of its three axes, to measure the component of the magnetic field in a particular direction, relative to the spatial orientation of the magnetometer 24, and thus the mobile device 10. However, the principles discussed below may be at least in part applied to scalar type magnetometers (not shown) in other example embodiments. The magnetometer 24, when operable, obtains or otherwise acquires readings including the direction of the magnetic field and its strength. Such readings are stored in a magnetometer sensor readings data store 28. It can also be appreciated that various components of the mobile device 10 are omitted from FIG. 5 for ease of illustration.

Applications 30 on the mobile device 10 may utilize the readings in the data store 28, for example an electronic compass application, a stud finder application, metal detector application, augmented reality based applications, etc., to name a few. As noted above, it has been found that other applications 30 and/or the mobile device's operating system (OS) can also benefit from determining if one or more properties of the readings are indicative of particular magnetic signatures 40, the magnetic signatures 40 being indicative of the presence of or coupling to another device. A magnetic signature module 26 is provided, which in this example is an application programming interface (API) that enables an application 30 to utilize properties of the readings acquired by the magnetometer 24 to execute one or more actions to control the mobile device 10. In this example, the magnetic signature module 26 is provided with access to the magnetometer sensor readings database 28 in order to determine if a particular magnetic influence of another device matches one of a set of one or more magnetic signatures 40. The magnetic signatures 40 are thus indicative of an expected magnetic influence from another object and they are stored in a magnetic signature database 36. The magnetic signature module 26 may be queried by an application 30, e.g. upon the application detecting an event trigger 32 such as a connection being made to another device or a change in device state, or may automatically determine if properties of a magnetometer reading match one of the predetermined magnetic signatures 40 in the database 36. It can be appreciated that the magnetic signatures 40 may be stored in the mobile device 10, e.g. at the time of manufacture, may be loaded onto the device during an installation or registration process (e.g. when being registered or paired with a new accessory), may be learned by the mobile device 10 when coupled to another object or device, or may be downloaded or otherwise provided to the mobile device 10 at some other time using a data input interface 38 of the mobile device 10 as illustrated. It can also be appreciated that the mobile device 10 may be configured to be compatible with particular other devices and accessories and thus any magnetic influence from such objects, devices or accessories can be empirically determined prior to usage of the device or accessory by the mobile device 10 in order to make its magnetic signature 40 available to the magnetic signature module 26.

Application N shown in FIG. 5 illustrates an example application 30 that interacts with the magnetic signature module 26 in order to determine if one or more actions should be executed. As noted above, such a determination can be made by the application 30, e.g. by independently detecting an event trigger 32, or can be made in response to a trigger provided directly from the magnetic signature module 26. For example, the magnetic signature module 26 can be operable to continuously or periodically sample the magnetic sensor readings database 28 to actively look for readings that match a magnetic signature 40 in the magnetic signature database 36. As illustrated in FIG. 5, the magnetic signature module 26 can also react to an event trigger 32 on the mobile device 10 to initiate a determination if one or more properties of a magnetometer reading matches one of a set of at least one predetermined magnetic signatures 40. An application 30 can also be configured to itself obtain the magnetometer sensor readings from the database 28 and, with access to one or more magnetic signatures 40, determine whether properties of the readings match a magnetic signature 40. This may be accomplished by providing such an application 30 with access to the magnetic signature database 36 or by enabling the application 30 to store a copy of one or more magnetic signatures 40.

Accordingly, matching properties of the magnetometer readings to predetermined magnetic signatures 40 and enabling one or more actions on the mobile device 10, can be implemented by an application 30 on the mobile device 10, the mobile device 10 itself (e.g. via its OS), an API such as the magnetic signature module 26, or any combination of one or more similar components on the mobile device 10.

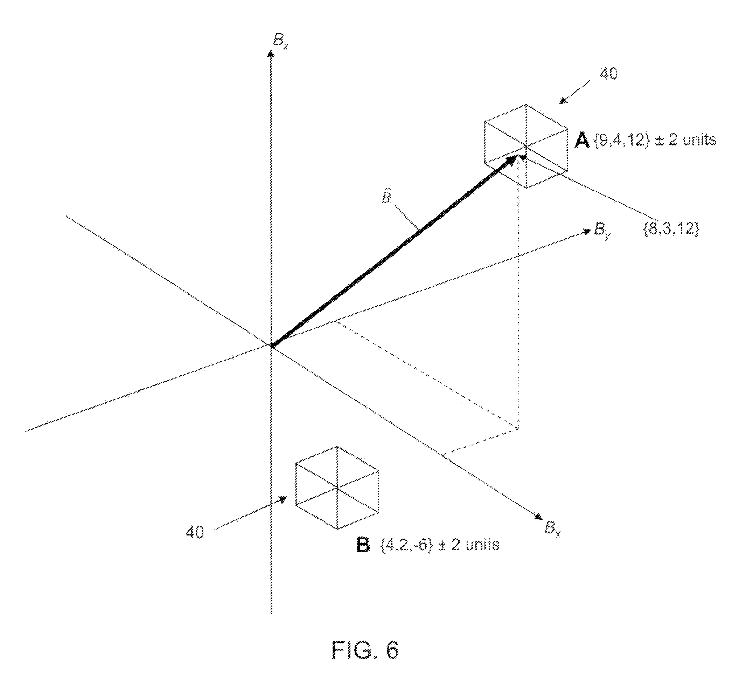

As noted above, in the example shown in FIG. 5, the magnetometer 24 is a vector type, three-axis magnetometer 24 that is operable to obtain readings along each of its three axes, to measure the component of the magnetic field in a particular direction, relative to the spatial orientation of the magnetometer 24. Using such a magnetometer 24, the position of the magnetic field vector (determined from the magnetometer readings) in three dimensional (3D) space can be evaluated in order to determine if the magnetic field vector matches a predetermined magnetic signature 40. It can be appreciated that the principles discussed herein can also be applied to two-axis magnetometers. Turning now to FIG. 6, a 3D magnetic space is shown, wherein a magnetic field in such space comprises three components, {*Bₓ*, *B_{y}*, *B_{z}*}. Each magnetic signature 40 can define a region in the magnetic space, having a particular centre and a region of +/- a predetermined number of units. For the purposes of illustration, a first signature 40 encompasses signature region A, which is centred at {9, 4, 12} and covers +/- 2 units along each axis. A second signature 40 encompasses signature region B, which is centred at {4, 2 -6} and covers +/- 2 units along each axis. Signature regions A and B are thus distinguishable from each other enabling the magnetic signature module 26 to determine if a particular magnetic field vector *̅B̅*̅ lies in a region covered by one of the these signatures 40, but not both. For example, signature region A may correspond to the magnetic influence of a holster 20 when the mobile device 10 is holstered in one orientation while region B corresponds to the magnetic influence of the holster 20 in another orientation. In another example, region A may correspond to an in-vehicle cradle 19 while region B corresponds to a holster 20 or bedside cradle 19 or any other device. It can be appreciated that the size of the region attributed to each signature 40 may vary and the examples shown in FIG. 6 are for illustrative purposes only.

The total magnetic field *̅B̅*̅ shown by way of example in FIG. 6 comprises components {8, 3, 12}. This would be considered a match with signature region A since the vector falls within the region A. The corresponding signature 40 is thus matched with the magnetic field currently experienced and can be used to initiate one or more actions to be executed on the mobile device 10.

It can be appreciated that for other types of magnetometers 24, such as a scalar magnetometer, and/or in other examples, the magnetic signature 40 can be detectable using other properties. A scalar magnetometer 24 that is capable of measuring the strength of a magnetic field, magnetic signatures 40 based on only field strength can be predetermined. For example, if it is determined that the magnetic field is typically 3 times stronger than the background level due to the Earth's influence when the mobile device 10 is face up in a holster 20, and 5 times stronger when face down in a holster 20, and 7 times stronger when in an in-vehicle cradle 19, magnetic signatures 40 representing 3x, 5x, and 7x the background magnetic field could be mapped to one or more actions associated with those different orientations and/or fixture types.

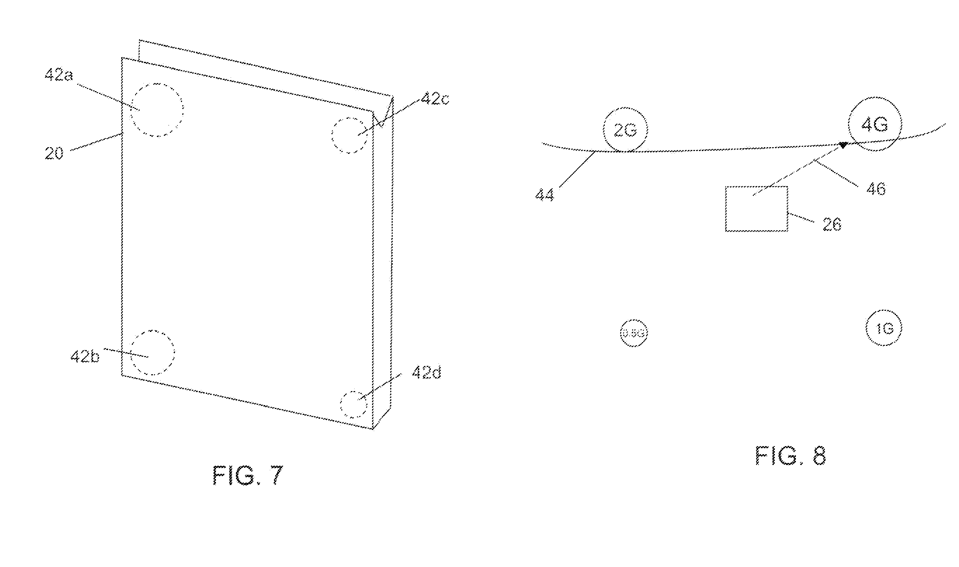

As discussed, the signatures 40 may distinguish the magnetic influence of one device from another device, or may distinguish different orientations of the mobile device 10 with respect to the same device, e.g. a holster 20. FIG. 7 illustrates one example configuration for a holster 20 that generates multiple distinguishable magnetic signatures 40 according to corresponding orientations of the mobile device 10 relative to the holster 20. In this example, four magnets 42a, 42b, 42c, 42d, are supported at four respective corner portions of the holster 20 (e.g. by being sewn into the holster 20 or attached thereto). Referring also to FIG. 8, in this example, each magnet 42 has a different strength, e.g. 4G, 2G, 1 G, and 0.5G, where G refers to the unit Gauss. It can be appreciated that the magnitude of the magnetic field 44 experienced by a magnetometer 26 located within an area defined by the locations of the magnets 42, is the sum of all fields from the magnets 42. The distance of the magnetometer 26 to each magnet 42 gives a different magnitude, and the direction of the magnetic field vector 46 is towards the magnet 42 that has the highest effect on the field. In this example, the 4G magnet has the most influence on the magnetic field 44 and thus the magnetic field vector 46 will point towards that magnet 42. As such, if the mobile device 10 were to be placed in the holster 20 in a different orientation, the position of the magnetometer 26 with respect to the magnets 42 would change and consequently a different magnetic field vector 46 would be detected. This enables different orientations with respect to the same other device to be distinguishable from each other.

It can be appreciated that the principles as applied in FIG. 8 are only one example and may apply in other device types. For example, a different type of holster 20 may include fewer magnets, e.g. only one, wherein the nature of the ways in which the mobile device 10 can be holstered causes that single magnet to provide distinguishable magnetic influences and thus distinct magnetic signatures 40. Moreover, these principles also apply to other magnetic influences such as those provided by magnetized materials, magnetic coatings or magnetic fields created by components of the other device. If the positioning of the magnetometer 24 with respect to any such magnetic influences changes when the mobile device 10 is in different orientations with respect to the other device, multiple magnetic signatures 40 may be detectable for the same other device.

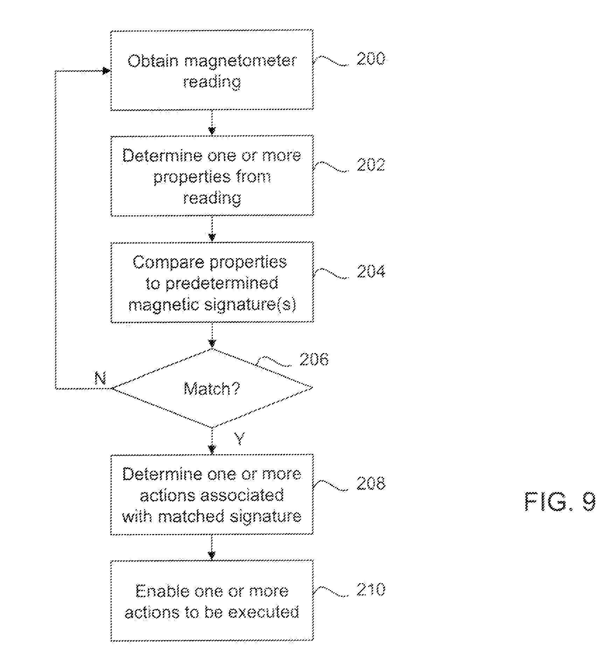

FIG. 9 illustrates an example set of computer executable operations that may be performed on the mobile device 10, e.g. by the magnetic signature module 26, for utilizing the predetermined magnetic signatures 40 to enable one or more actions to be executed. At 200, a magnetometer reading is obtained, e.g. by accessing data stored in the magnetometer sensor readings database 28. One or more properties from the reading are then obtained at 202. In this example, utilizing one or more properties of the reading comprises determining a magnetic field vector 46. The one or more properties are then compared to a set of one or more predetermined magnetic signatures 40 at 204, e.g. by accessing the magnetic signatures database 36. The magnetic signature module 26 then determines at 206 whether or not the one or more properties match one of the magnetic signatures 40. If not, the process may return to 200, e.g. if periodic readings are examined. If a match has been found, one or more actions that are associated with the matched signature are determined at 208, and the one or more actions are enabled at 210. This may include instructing another component to execute one or more of the actions, or performing the actions directly.

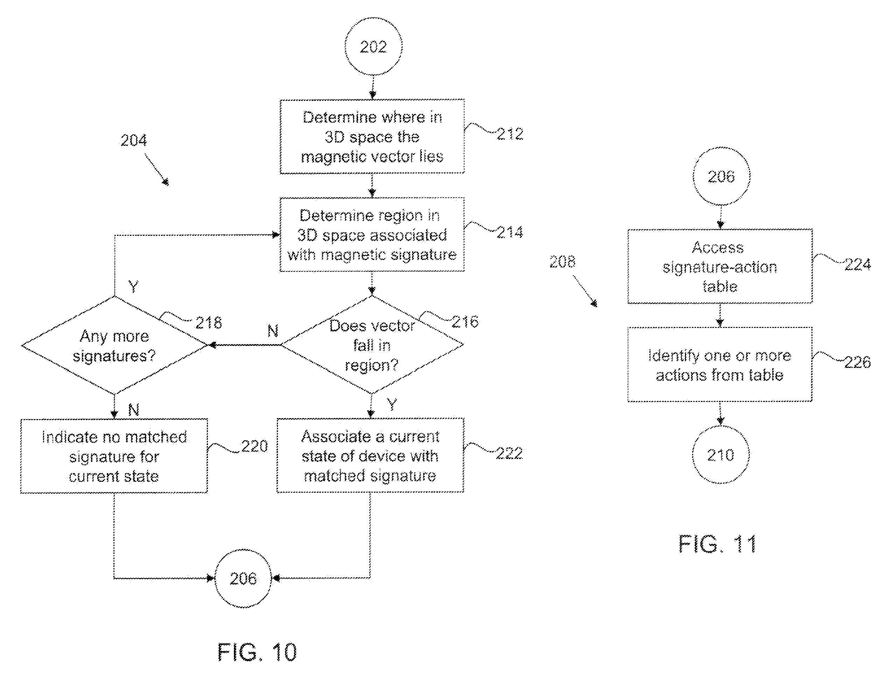

An example set of operations for performing 204 is shown in FIG. 10. In this example, the magnetic field vector 46 is used to match the mobile device's current state to one associated with a particular magnetic signature 40. At 212, the magnetic signature module 26 determines where in the 3D space the magnetic field vector 46 lies (e.g. coordinates {*Bₓ,B_{y},B_{z}*}). The magnetic signature module 26 would also determine, for a first magnetic signature 40 to which the field vector 46 is being compared, the region in the 3D space associated with that magnetic signature 40 at 214. If the magnetic signature module 26 determines at 216 that the magnetic field vector does not fall in the associated region, the magnetic signature module 26 can determine at 218 if there are more magnetic signatures 40 to be compared. If so, the process may be repeated at 214. If not, the magnetic signature module 26 may indicate that no matched signature exists for the current state of the mobile device 10 at 220. It can be appreciate that operation 220 may be an internal command or may be an external command to notify another application 30 or the OS of the mobile device 10 if a query has been made and requires a response, for example.

If the magnetic signature module 26 determines at 216 that the magnetic field vector 46 falls in the region defined by the particular magnetic signature 40, the current state of the mobile device 10 is then associated with that magnetic signature 40 to thus be interpreted as a match at 206.

It can be appreciated that the operations shown in FIG. 10 can also be adapted for a scalar-type magnetometer 24 wherein operations 212 to 216 would comprise determining if a detected field strength has a similar scaling as one indicated in a particular magnetic signature 40. Similar to the example shown in FIG. 6, for a scalar magnetometer 24 a range +/- a particular number of units or portions of a unit can be used to effectively define a scalar range for each signature 40.

Turning now to FIG. 11, an example set of operations for performing 208 is shown. In this example, the determination made at 208 is performed by accessing a table (not shown) at 224, that correlates a magnetic signature 40 to one or more associated actions (i.e. a signature-action table). Such a table may be contained in the magnetic signature database 36 or stored by the magnetic signature module 26 or an application 30, etc. The table is then used at 226 to identify the one or more actions to be enabled at 210.

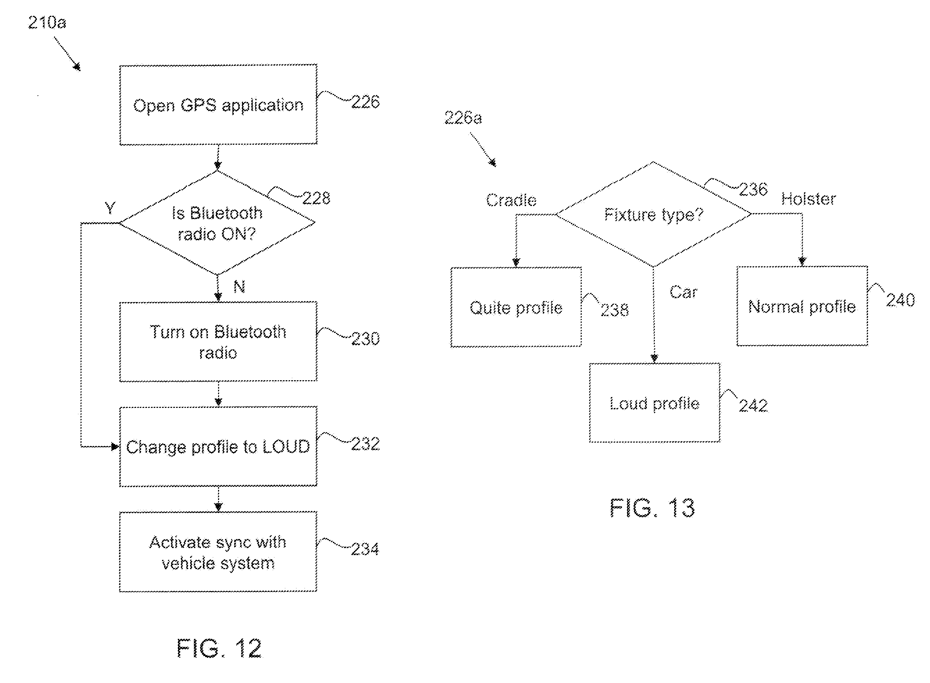

Various actions associated with particular magnetic signatures 40 may be executed by the mobile device 10. Such actions may be related to the performance of an application 30 or the mobile device 10 and may pre-emptively perform various operations, suppress various options (e.g. to conserve battery power) or execute any predetermined instruction. FIG. 12 illustrates one example set of operations 110a that may be performed in response to the magnetic signature module 26 detecting that the mobile device 10 is coupled to an in vehicle cradle 19 or other fixture. In this example, matching a magnetometer reading to a magnetic signature 40 associated with the in-vehicle cradle 19 is used to pre-emptively open a global positioning system (GPS) application at 226 and determine at 228 if a Bluetooth radio is ON or active. For example, a set of user preferences or default settings may associate the GPS application and the Bluetooth radio with use of the in-vehicle cradle 19. This allows the mobile device 10 to automatically initiate and display a relevant application 30 and pre-emptively determine whether the mobile device 10 can sync with the vehicle for hands-free calling. In this way, should the Bluetooth radio have been turned off at some point to conserve power, the magnetic signature module 26 can be utilized to ensure that the Bluetooth radio is ON and ready to be paired whenever the mobile device 10 is cradled in the vehicle. The user would therefore not have to remember to turn on their Bluetooth radio before entering their vehicle or suddenly realize their hands-free option is not available when they receive a call or need to make a call.

If the Bluetooth radio is not ON, it may be turned on at 230. If not, in this example, a next operation is performed. In addition to opening the GPS application and ensuring the Bluetooth radio is ON, a notification profile can also be changed to suit the particular environment. For example, the notification profile could be set to be LOUD (i.e. relatively loud audible tones when compared to other profiles) at 232 to ensure that the mobile device 10 can be heard over vehicle noise. Similarly, at 234, an sync with another vehicle system can be initiated, e.g. an infotainment, subscription-based communication system, security system, etc.

A set of actions similar to those illustrated in FIG. 12 may be associated with various states of the mobile device 10 in turn associated with interaction with another device. For example, a magnetic signature 40 associated with a bedside cradle 40 could be used to trigger a bedtime mode for the mobile device 10. Similarly, the detection of particular orientations of the mobile device 10 in a holster 20 can trigger different actions. For example, in the orientation shown in FIG. 3, flash notifications using the light 21 may be permitted but such notifications could be suppressed if the mobile device 10 is in the orientation shown in FIG. 4. In another example, if a cut-out exists on the holster 20, some orientations may permit use of the display 14 whereas others turn off a backlight to conserve power.

FIG. 13 illustrates another example, wherein different outcomes of the same action are taken according to the magnetic signature 40 that is detected. In this example, the magnetic signature module 26 determines which fixture type the mobile device 10 is coupled to at 236 in order to select an appropriate notification profile. If the magnetic reading matches a magnetic signature 40 associated with a cradle 19 (e.g. a desk or bedside cradle 19), a quiet profile is applied (or confirmed) at 238. If the matched magnetic signature 40 is associated with an in-vehicle cradle 19, a loud profile is applied (or confirmed) at 242. If the matched magnetic signature 40 is associated with the holster 20, a normal profile is applied (or confirmed) at 240.

It can be appreciated that multiple sets of actions can be performed accordingly to a particular trigger. For example, the operations shown in FIG. 13 may be performed on a continual basis to control notifications and, if the in-vehicle cradle 19 is detected at 236, the set of operations shown in FIG. 12 could also be performed in parallel (minus operation 232 which is performed at 242). As such, it can be appreciated that the one or more actions associated with a particular magnetic signature 40 can be performed in various ways and may be grouped together in order to be modularly applied under different circumstances.

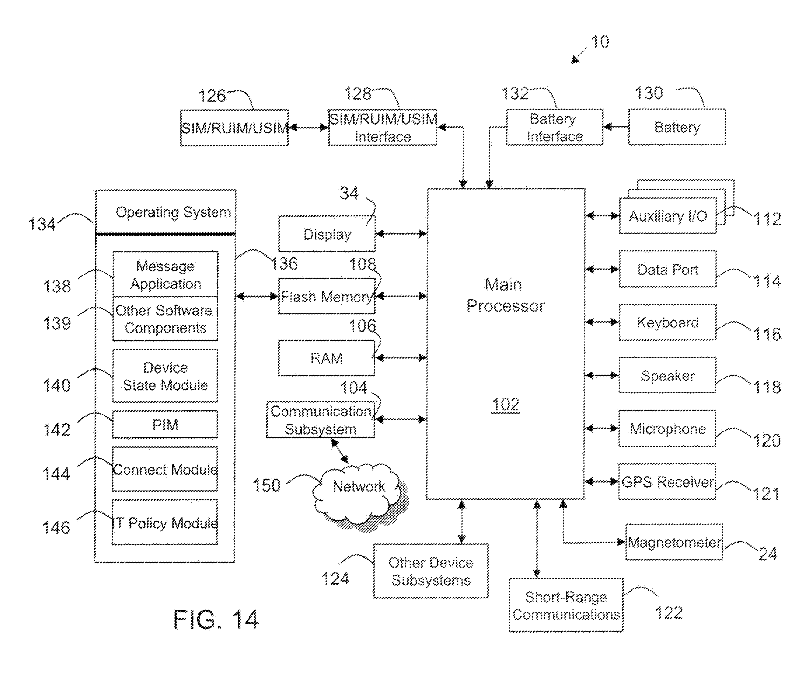

Referring now to FIG 14, shown therein is a block diagram of an example embodiment of a mobile device 10, which provides further detail thereof. The mobile device 10 comprises a number of components such as a main processor 102 that controls the overall operation of the mobile device 10. Communication functions, including data and voice communications, are performed through a communication subsystem 104. The communication subsystem 104 receives messages from and sends messages to a wireless network 150. In this example embodiment of the mobile device 10, the communication subsystem 104 is configured in accordance with the Global System for Mobile Communication (GSM) and General Packet Radio Services (GPRS) standards. The GSM/GPRS wireless network is used worldwide and it is expected that these standards will be superseded eventually by 3G and 4G networks such as EDGE, UMTS and HSDPA, LTE, Wi-Max etc. New standards are still being defined, but it is believed that they will have similarities to the network behaviour described herein, and it will also be understood by persons skilled in the art that the embodiments described herein are intended to use any other suitable standards that are developed in the future. The wireless link connecting the communication subsystem 104 with the wireless network 150 represents one or more different Radio Frequency (RF) channels, operating according to defined protocols specified for GSM/GPRS communications. With newer network protocols, these channels are capable of supporting both circuit switched voice communications and packet switched data communications.

The main processor 102 also interacts with additional subsystems such as a Random Access Memory (RAM) 106, a flash memory 108, a display 34, an auxiliary input/output (I/O) subsystem 112, a data port 114, a keyboard 116, a speaker 118, a microphone 120, GPS receiver 121, magnetometer 24, short-range communications 122, and other device subsystems 124.

Some of the subsystems of the mobile device 10 perform communication-related functions, whereas other subsystems may provide "resident" or on-device functions. By way of example, the display 34 and the keyboard 116 may be used for both communication-related functions, such as entering a text message for transmission over the network 150, and device-resident functions such as a calculator or task list.

The mobile device 10 can send and receive communication signals over the wireless network 150 after required network registration or activation procedures have been completed. Network access is associated with a subscriber or user of the mobile device 10. To identify a subscriber, the mobile device 10 may use a subscriber module. Examples of such subscriber modules include a Subscriber identity Module (SIM) developed for GSM networks, a Removable User identity Module (RUIM) developed for CDMA networks and a Universal Subscriber Identity Module (USIM) developed for 3G networks such as UMTS. In the example shown, a SIM/RUIM/USIM 126 is to be inserted into a SIM/RUIM/USIM interface 128 in order to communicate with a network. The SIM/RUIM/USIM component 126 is one type of a conventional "smart card" that can be used to identify a subscriber of the mobile device 10 and to personalize the mobile device 10, among other things. Without the component 126, the mobile device 10 may not be fully operational for communication with the wireless network 150. By inserting the SIM/RUIM/USIM 126 into the SIM/RUIM/USIM interface 128, a subscriber can access all subscribed services. Services may include: web browsing and messaging such as e-mail, voice mail, SMS, and MMS. More advanced services may include: point of sale, field service and sales force automation. The SIM/RUIM/USIM 126 includes a processor and memory for storing information. Once the SIM/RUIM/USIM 126 is inserted into the SIM/RUIM/USIM interface 128, it is coupled to the main processor 102. In order to identify the subscriber, the SIM/RUIM/USIM 126 can include some user parameters such as an International Mobile Subscriber identity (IMSI). An advantage of using the SIM/RUIM/USIM 126 is that a subscriber is not necessarily bound by any single physical mobile device. The SIM/RUIM/USIM 126 may store additional subscriber information for a mobile device as well, including datebook (or calendar) information and recent call information. Alternatively, user identification information can also be programmed into the flash memory 108.

The mobile device 10 is typically a battery-powered device and may include a battery interface 132 for receiving one or more batteries 130 (typically rechargeable). In at least some embodiments, the battery 130 can be a smart battery with an embedded microprocessor. The battery interface 132 is coupled to a regulator (not shown), which assists the battery 130 in providing power V+ to the mobile device 10. Although current technology makes use of a battery, future technologies such as micro fuel cells may provide the power to the mobile device 10.

The mobile device 10 also includes an operating system (OS) 134 and software components 136 to 146. The operating system 134 and the software components 136 to 146 that are executed by the main processor 102 are typically stored in a persistent store such as the flash memory 108, which may alternatively be a read-only memory (ROM) or similar storage element (not shown). Those skilled in the art will appreciate that portions of the operating system 134 and the software components 136 to 146, such as specific device applications, or parts thereof, may be temporarily loaded into a volatile store such as the RAM 106. Other software components can also be included, as is well known to those skilled in the art.

The subset of software applications 136 that control basic device operations, including data and voice communication applications, may be installed on the mobile device 10 during its manufacture. Other software applications include a message application 138 that can be any suitable software program that allows a user of the mobile device 10 to send and receive electronic messages. Various alternatives exist for the message application 138 as is well known to those skilled in the art. Messages that have been sent or received by the user are typically stored in the flash memory 108 of the mobile device 10 or some other suitable storage element in the mobile device 10. In at least some embodiments, some of the sent and received messages may be stored remotely from the mobile device 10 such as in a data store of an associated host system that the mobile device 10 communicates with.

The software applications can further comprise a device state module 140, a Personal Information Manager (PIM) 142, and other suitable modules (not shown). The device state module 140 provides persistence, i.e. the device state module 140 ensures that important device data is stored in persistent memory, such as the flash memory 108, so that the data is not lost when the mobile device 10 is turned off or loses power.

The PIM 142 includes functionality for organizing and managing data items of interest to the user, such as, but not limited to, e-mail, contacts, calendar events, voice mails, appointments, and task items. A PIM application has the ability to send and receive data items via the wireless network 150. PIM data items may be seamlessly integrated, synchronized, and updated via the wireless network 150 with the mobile device subscriber's corresponding data items stored and/or associated with a host computer system. This functionality creates a mirrored host computer on the mobile device 10 with respect to such items. This can be particularly advantageous when the host computer system is the mobile device subscriber's office computer system.

The mobile device 10 may also comprise a connect module 144, and an IT policy module 146. The connect module 144 implements the communication protocols that are required for the mobile device 10 to communicate with the wireless infrastructure and any host system, such as an enterprise system, that the mobile device 10 is authorized to interface with.

The connect module 144 includes a set of APIs that can be integrated with the mobile device 10 to allow the mobile device 10 to use any number of services associated with the enterprise system. The connect module 144 allows the mobile device 10 to establish an end-to-end secure, authenticated communication pipe with a host system (not shown). A subset of applications for which access is provided by the connect module 144 can be used to pass IT policy commands from the host system to the mobile device 10. This can be done in a wireless or wired manner. These instructions can then be passed to the IT policy module 146 to modify the configuration of the device 10. Alternatively, in some cases, the IT policy update can also be done over a wired connection.

The IT policy module 146 receives IT policy data that encodes the IT policy. The IT policy module 146 then ensures that the IT policy data is authenticated by the mobile device 100. The IT policy data can then be stored in the flash memory 106 in its native form. After the IT policy data is stored, a global notification can be sent by the IT policy module 146 to all of the applications residing on the mobile device 10. Applications for which the IT policy may be applicable then respond by reading the IT policy data to look for IT policy rules that are applicable.

Other types of software applications or components 139 can also be installed on the mobile device 10. These software applications 139 can be pre-installed applications (i.e. other than message application 138) or third party applications, which are added after the manufacture of the mobile device 10. Examples of third party applications include games, calculators, utilities, etc.

The additional applications 139 can be loaded onto the mobile device 10 through at least one of the wireless network 150, the auxiliary I/O subsystem 112, the data port 114, the short-range communications subsystem 122, or any other suitable device subsystem 124. This flexibility in application installation increases the functionality of the mobile device 10 and may provide enhanced on-device functions, communication-related functions, or both. For example, secure communication applications may enable electronic commerce functions and other such financial transactions to be performed using the mobile device 10.

The data port 114 enables a subscriber to set preferences through an external device or software application and extends the capabilities of the mobile device 10 by providing for information or software downloads to the mobile device 10 other than through a wireless communication network. The alternate download path may, for example, be used to load an encryption key onto the mobile device 10 through a direct and thus reliable and trusted connection to provide secure device communication.

The data port 114 can be any suitable port that enables data communication between the mobile device 10 and another computing device. The data port 114 can be a serial or a parallel port. In some instances, the data port 114 can be a USB port that includes data lines for data transfer and a supply line that can provide a charging current to charge the battery 130 of the mobile device 10.

The short-range communications subsystem 122 provides for communication between the mobile device 10 and different systems or devices, without the use of the wireless network 150. For example, the subsystem 122 may include an infrared device and associated circuits and components for short-range communication. Examples of short-range communication standards include standards developed by the Infrared Data Association (IrDA), Bluetooth, and the 802.11 family of standards developed by IEEE.

In use, a received signal such as a text message, an e-mail message, or web page download may be processed by the communication subsystem 104 and input to the main processor 102. The main processor 102 may then process the received signal for output to the display 34 or alternatively to the auxiliary I/O subsystem 112. A subscriber may also compose data items, such as e-mail messages, for example, using the keyboard 116 in conjunction with the display 34 and possibly the auxiliary I/O subsystem 112. The auxiliary subsystem 112 may comprise devices such as: a touch screen, mouse, track ball, infrared fingerprint detector, or a roller wheel with dynamic button pressing capability. The keyboard 116 is an alphanumeric keyboard and/or telephone-type keypad. However, other types of keyboards may also be used. A composed item may be transmitted over the wireless network 150 through the communication subsystem 104.

For voice communications, the overall operation of the mobile device 10 in this example is substantially similar, except that the received signals are output to the speaker 118, and signals for transmission are generated by the microphone 120. Alternative voice or audio I/O subsystems, such as a voice message recording subsystem, can also be implemented on the mobile device 10. Although voice or audio signal output is accomplished primarily through the speaker 118, the display 34 can also be used to provide additional information such as the identity of a calling party, duration of a voice call, or other voice call related information.

It will be appreciated that any module or component exemplified herein that executes instructions may include or otherwise have access to computer readable media such as storage media, computer storage media, or data storage devices (removable and/or non-removable) such as, for example, magnetic disks, optical disks, or tape. Computer storage media may include volatile and non-volatile, removable and non-removable media implemented in any method or technology for storage of information, such as computer readable instructions, data structures, program modules, or other data. Examples of computer storage media include RAM, ROM, EEPROM, flash memory or other memory technology, CD-ROM, digital versatile disks (DVD) or other optical storage, magnetic cassettes, magnetic tape, magnetic disk storage or other magnetic storage devices, or any other medium which can be used to store the desired information and which can be accessed by an application, module, or both. Any such computer storage media may be part of the mobile device 10 (or other computing or communication device that utilizes similar principles) or accessible or connectable thereto. Any application or module herein described may be implemented using computer readable/executable instructions that may be stored or otherwise held by such computer readable media

Although the above principles have been described with reference to certain specific embodiments, various modifications thereof will be apparent to those skilled in the art without departing from the scope of the claims appended hereto.

## Claims

1. A method of controlling an electronic device (10), the method comprising:
obtaining (200) a reading from a magnetometer (24) of the electronic device;
determining (202,204,206) whether one or more properties of the reading matches at least one magnetic signature from a set of magnetic signatures, the set comprising a plurality of magnetic signatures each being indicative of the presence of respective ones of a plurality of other objects (19, 20, 40) and including a plurality of magnetic signatures each being indicative of the presence and a particular orientation of the electronic device with respect to a particular object, each magnetic signature being indicative of an expected magnetic influence from another object;
if the one or more properties match a particular magnetic signature from the set of magnetic signatures, determining (208) the one or more actions associated with the particular magnetic signature; and
enabling (210) the one or more actions to be performed using the electronic device.

2. The method according to any one of claim 1, wherein the one or more properties of the reading comprises a location of an associated magnetic field vector (B) in three-dimensional space.

3. The method according to claim 2, wherein each magnetic signature comprises a region of the three-dimensional space, wherein if the magnetic field vector lies in the region of the particular magnetic signature, the one or more properties matches the particular magnetic signature.

4. The method according to any one of claims 1 to 3, wherein at least one of the magnetic signatures is stored (36) on the electronic device and is associated with an accessory for the electronic device.

5. The method according to claim 4, wherein the accessory is any one of an in-vehicle cradle (19), a desktop cradle, a bedside cradle (40), and a holster (20).

6. The method according to any one of claims 1 to 5, further comprising:
obtaining one or more of the predetermined magnetic signatures; and
storing the one or more predetermined magnetic signatures to a memory on the electronic device.

7. The method according to any one of claims 1 to 6, wherein the expected magnetic influence from the other object is caused by any one or more of: a magnet, a magnetized material, a magnetic coating, or a magnetic field created by a component of the other object.

8. The method according to any one of claims 1 to 7, wherein the one or more actions comprise any one or more of: controlling a notification profile for the electronic device; controlling one or more alerts provided by the electronic device; and controlling a display on the electronic device.

9. The method according to any one of claims 1 to 8, wherein the other object comprises an in-vehicle cradle, and the one or more actions comprising any one or more of: initiating a global positioning system application; having a Bluetooth radio activated; activating a synchronization with a vehicle system; and changing to a notification profile having a relatively loud profile tone.

10. An electronic device comprising a processor, a memory, and a magnetometer, the memory comprising computer executable instructions for controlling the electronic device, the computer executable instructions comprising instructions for performing the method according to any one of claims 1 to 9.

11. A computer readable storage medium comprising computer executable instructions for controlling an electronic device according to claim 10, the computer executable instructions comprising instructions for performing the method according to any one of claims 1 to 9.

## Patentansprüche

1. Verfahren zum Kontrollieren einer Elektronikvorrichtung (10), wobei das Verfahren Folgendes aufweist:
Erhalten (200) einer Lesung von einem Magnetometer (24) der Elektronikvorrichtung,
Bestimmen (202, 204, 206), ob eine oder mehrere Eigenschaften der Lesung zu mindestens einer magnetischen Signatur aus einem Satz von magnetischen Signaturen passen, wobei der Satz eine Vielzahl von magnetischen Signaturen aufweist, wobei jede die Anwesenheit von jeweiligen einer Vielzahl von anderen Objekten (19, 20, 40) angibt, und der eine Vielzahl von magnetischen Signaturen aufweist, wobei jede die Anwesenheit und eine bestimmte Orientierung der Elektronikvorrichtung in Bezug auf ein bestimmtes Objekt angibt, wobei jede magnetische Signatur einen erwarteten magnetischen Einfluss von einem weiteren Objekt angibt,
Bestimmen (208) der einen oder mehrerer Aktionen, die mit einer bestimmten magnetischen Signatur aus dem Satz von magnetischen Signaturen verknüpft sind, wenn die eine oder die mehreren Eigenschaften zu der bestimmten magnetischen Signatur passen, und
Aktivieren (210) der einen oder der mehreren Aktionen, die durchgeführt werden sollen, unter Verwendung der Elektronikvorrichtung.

2. Verfahren nach Anspruch 1, wobei die eine oder die mehreren Eigenschaften der Lesung einen Ort eines verknüpften magnetischen Feldvektors (B) im dreidimensionalen Raum aufweist.

3. Verfahren nach Anspruch 2, wobei jede magnetische Signatur eine Region des dreidimensionalen Raums aufweist, wobei, wenn der magnetische Feldvektor in der Region der bestimmten magnetischen Signatur liegt, die eine oder die mehreren Eigenschaften zur bestimmten magnetischen Signatur passen.

4. Verfahren nach einem der Ansprüche 1 bis 3, wobei mindestens eine der magnetischen Signaturen auf der Elektronikvorrichtung gespeichert (36) wird und mit einem Zubehörteil für die Elektronikvorrichtung verknüpft wird.

5. Verfahren nach Anspruch 4, wobei das Zubehörteil ein beliebiges aus einer In-Fahrzeug-Ladestation (19), einer Desktop- bzw. Schreibtischladestation, einer Bettseitenladestation (40) bzw. einer Ladestation am Bett und einem Etui bzw. einem Holster (20) ist.

6. Verfahren nach einem der Ansprüche 1 bis 5, ferner mit:
Erhalten einer oder mehrerer der vorbestimmten magnetischen Signaturen und
Speichern der einem oder der mehreren magnetischen Signaturen in einen Speicher der Elektronikvorrichtung.

7. Verfahren nach einem der Ansprüche 1 bis 6, wobei der erwartete magnetische Einfluss von dem anderen Objekt von einem oder mehreren aus Folgendem veranlasst wird: einem Magnet, einem magnetisierten Material, einer magnetischen Beschichtung oder einem magnetischen Feld, das von einer Komponente des anderen Objekts erzeugt ist.

8. Verfahren nach einem der Ansprüche 1 bis 7, wobei die eine oder die mehreren Aktionen eines oder mehrere aus Folgendem aufweisen: Steuern eines Mitteilungsprofils für eine Elektronikvorrichtung, Steuern eines oder mehrerer Alarme, die von der Elektronikvorrichtung vorgesehen sind, und Steuern einer Anzeige auf der Elektronikvorrichtung.

9. Verfahren nach einem der Ansprüche 1 bis 8, wobei das andere Objekt eine In-Fahrzeug-Ladestation aufweist, und die eine oder die mehren Aktionen ein beliebiges oder beliebige aus Folgendem aufweisen: Einleiten einer Weltweitortungssystem-Anwendung bzw. einer GPS-Anwendung, Aktivieren-Lassen eines Bluetooth-Funks, Aktivieren einer Synchronisation mit einem Fahrzeugsystem und Wechseln auf ein Mitteilungsprofil mit einem relativ lauten Profilton.

10. Elektronikvorrichtung mit einem Prozessor, einem Speicher und einem Magnetometer, wobei der Speicher von einem Computer ausführbare Anweisungen zum Steuern der Elektronikvorrichtung aufweist, wobei die von dem Computer ausführbaren Anweisungen Anweisungen zum Durchführen des Verfahrens nach einem der Ansprüche 1 bis 9 aufweisen.

11. Computerlesbares Speichermedium mit von einem Computer ausführbaren Anweisungen zum Steuern einer Elektronikvorrichtung nach Anspruch 10, wobei die von dem Computer ausführbaren Anweisungen Anweisungen zum Durchführen des Verfahrens nach einem der Ansprüche 1 bis 9 aufweisen.

## Revendications

1. Procédé de commande d'un dispositif électronique (10), le procédé comprenant le fait :
d'obtenir (200) un relevé à partir d'un magnétomètre (24) du dispositif électronique ;
de déterminer (202, 204, 206) si une ou plusieurs propriétés du relevé correspondent à au moins une signature magnétique parmi un ensemble de signatures magnétiques, l'ensemble comprenant une pluralité de signatures magnétiques dont chacune indiquant la présence d'objets respectifs d'une pluralité d'autres objets (19, 20, 40) et comportant une pluralité de signatures magnétiques dont chacune indiquant la présence et une orientation particulière du dispositif électronique par rapport à un objet particulier, chaque signature magnétique indiquant une influence magnétique prévue d'un autre objet ;
de déterminer (208), si la ou les plusieurs propriétés correspondent à une signature magnétique particulière parmi l'ensemble de signatures magnétiques, la ou les plusieurs actions associées à la signature magnétique particulière ; et
de permettre (210) à l'action ou aux plusieurs actions d'être mises en oeuvre en utilisant le dispositif électronique.

2. Procédé selon la revendication 1, dans lequel la ou les plusieurs propriétés du relevé comprennent un emplacement d'un vecteur de champ magnétique associé (B) dans un espace tridimensionnel.

3. Procédé selon la revendication 2, dans lequel chaque signature magnétique comprend une zone de l'espace tridimensionnel, où si le vecteur de champ magnétique se situe dans la zone de la signature magnétique particulière, la ou les plusieurs propriétés correspondent à la signature magnétique particulière.

4. Procédé selon l'une quelconque des revendications 1 à 3, dans lequel au moins l'une des signatures magnétiques est stockée (36) sur le dispositif électronique et est associée à un accessoire pour le dispositif électronique.

5. Procédé selon la revendication 4, dans lequel l'accessoire est l'un quelconque parmi un support à bord d'un véhicule (19), un support pour bureau, un support pour chevet (40), et un étui (20).

6. Procédé selon l'une quelconque des revendications 1 à 5, comprenant en outre le fait :
d'obtenir une ou plusieurs signatures parmi les signatures magnétiques prédéterminées ; et
de stocker la ou les plusieurs signatures magnétiques prédéterminées dans une mémoire sur le dispositif électronique.

7. Procédé selon l'une quelconque des revendications 1 à 6, dans lequel l'influence magnétique prévue de l'autre objet est provoquée par l'un quelconque ou plusieurs parmi : un aimant, un matériau magnétisé, un revêtement magnétique, ou un champ magnétique créé par un composant de l'autre objet.

8. Procédé selon l'une quelconque des revendications 1 à 7, dans lequel la ou les plusieurs actions comprennent l'une quelconque ou plusieurs parmi : la commande d'un profil de notification pour le dispositif électronique ; la commande d'une ou de plusieurs alertes fournies par le dispositif électronique ; et la commande d'un affichage sur le dispositif électronique.

9. Procédé selon l'une quelconque des revendications 1 à 8, dans lequel l'autre objet comprend un support à bord d'un véhicule, et la ou les plusieurs actions comprenant l'un(e) quelconque ou plusieurs parmi : l'initiation d'une application de système mondial de positionnement ; le fait d'avoir une radio Bluetooth activée ; l'activation d'une synchronisation avec un système de véhicule ; et le passage à un profil de notification ayant une tonalité de profil relativement forte.

10. Dispositif électronique comprenant un processeur, une mémoire, et un magnétomètre, la mémoire comprenant des instructions pouvant être exécutées par ordinateur pour commander le dispositif électronique, les instructions pouvant être exécutées par ordinateur comprenant des instructions destinées à mettre en oeuvre le procédé selon l'une quelconque des revendications 1 à 9.

11. Support de stockage lisible par ordinateur comprenant des instructions pouvant être exécutées par ordinateur pour commander un dispositif électronique selon la revendication 10, les instructions pouvant être exécutées par ordinateur comprenant des instructions destinées à mettre en oeuvre le procédé selon l'une quelconque des revendications 1 à 9.
